Europäisches Patentamt

European Patent Office

Office européen des brevets

(19)

(11) Publication number: **0 424 301 A2**

# EUROPEAN PATENT APPLICATION

(12)

(21) Application number: **90480136.2**

(22) Date of filing: **04.09.90**

(51) Int. Cl.⁵: **G06F 11/10**

(30) Priority: **18.10.89 US 423814**

(43) Date of publication of application:
**24.04.91 Bulletin 91/17**

(84) Designated Contracting States:
**DE FR GB**

(71) Applicant: **International Business Machines Corporation**
**Old Orchard Road**
**Armonk, N.Y. 10504(US)**

(72) Inventor: **Aichelmann, Fredrick John, Jr.**
**28 Taconic Drive**
**Hopewell Junction, N.Y. 12533(US)**
Inventor: **Blake, Robert Martin**
**3 Central Avenue**
**Wappingers Falls, New York 12590(US)**

(74) Representative: **Tubiana, Max**
**Compagnie IBM France Département de Propriété Intellectuelle**
**F-06610 La Gaude(FR)**

(54) **Overlapped data scrubbing with data refreshing.**

(57) A system for refreshing and scrubbing data contained in a DRAM during each and every refresh cycle is disclosed. Briefly stated, a standard refresh address counter has its bit length extended with the result that the-extended bits are used as a column address which when used with a conventional row address during a refresh cycle are used to select memory locations which are refreshed and scrubbed while adjacent memory locations are refreshed only. The read/write enable lead is deactivated during the refresh cycle. The DRAM is in effect forced into performing a read operation with the result that data is refreshed and scrubbed contemporaneously as normally done during a read or write.

EP 0 424 301 A2

FIG.2A

## OVERLAPPED DATA SCRUBBING WITH DATA REFRESHING

### Field of the Invention

This invention relates, in general, to memory devices having on board correction circuitry and, more particularly, to apparatus for data scrubbing during each data refresh cycle.

### Background of the Invention

Recently, semiconductor memory devices, and particularly, dynamic random access memory devices (DRAM) have been increasing significantly in density. Each new generation of DRAMs usually quadruples the memory capacity over previous generations. As a result, the physical size of each memory cell must decrease. Further, as a result of such high density packaging, it is inherent that a certain percentage of devices will have defective areas known as "hard errors". A hard error is the result of a physical defect in a memory location. While increased manufacturing experience will lower the incidence or occurrence of hard errors, such errors must be compensated for. Otherwise, unacceptably low manufact- uring yield rates for semiconductors will result. Presently, such known methods of dealing with hard errors is the use of error correction circuitry, which for the most part has been resident on the circuit board upon which the memory devices are mounted. Recently however, error correction circuitry (EGG) is being placed onto each memory chip. Such error correction codes detect and correct hard errors as they are read out of memory. This is accomplished through the use of error check code words using error correction techniques such as, for example, Hamming codes.

Also inherent in the manufacture of high density memories is the potential for "soft errors". Soft errors can be the result of any spurious condition and are generally completely at random and not repeatable. The major reason for soft errors is the presence of alpha particles. Alpha particles are charged particles which are emitted from various materials used for packaging and construction of an integrated circuit which are inherent in the process of natural radioactive decay. These particles infringe upon the various portions of the semiconductor memory and may randomly upset the charge distribution.

Error correction codes are also used to detect and correct soft errors. These error correction codes themselves utilize additional bits of information which have been generated from the original data word as mathematical permutations thereof and are stored with each data word. By reversing the process of generating the error check code word, it is possible to detect and correct errors in the associated data word. The number of additional bits in an error check code word directly relates to the number of errors in each word which may be detected and which may be corrected. Accordingly, the longer the error code utilized, the more errors for each data word that may be detected and corrected. For the most part, most codes are only of sufficient lengths so as to detect double errors but may correct only a single error.

The fact that soft errors occur readily is inherent in the architecture of dynamic random access memories. In such devices, each bit of data is stored in a memory cell which is, in essence, an extremely small capacitor which holds an electrical charge. The presence or absence of this electrical charge indicates a 1 or 0. However, with the increasing density of memories, the size and therefore the ability of each capacitor to hold a charge decreases as does the size of the capacitor. Accordingly, with all types of dynamic memory devices, and particularly with higher density memory devices, the refresh operation is necessary to provide a "new" charge to each memory cell before the capacitor discharges to an unacceptably low level.

Accordingly, present day technology calls for a group of memory cells to periodically be activated and thereafter re-written into the same memory location, thereby "recharging" the memory cell.

A number of schemes have been devised to either refresh memory or correct memory locations (commonly referred to as data scrubbing) with the use of on-board or external circuitry. However, although conventional data scrubbing applied only to soft errors it is now generally utilized to encompass soft and hard errors. Although hard errors are in fact not correctable, they are handled in essentially the exact same fashion as a soft error. For this reason, data scrubbing typically encompasses or is meant to include hard and soft errors. In order to accomplish refresh, many schemes typically utilize a row address (RAS) for refresh circuitry. This row address is comprised of a bit word in order to address each row in the semi- conductor memory device. Typically, each row is N bits wide.

Further, a number of schemes have been utilized to coordinate or simultaneously perform refresh and scrub activities. Examples of such attempts to refresh and correct with off chip circuitry may be found in U.S. Patent No. 4,694,454 "Dynamic Memory Diagnosis and Error Correction Apparatus" issued September 15, 1987 to Matsuura; U.S. Patent No. 4,682, 328 "Dynamic Memory Refresh and Parity Checking Circuit" issued July 21, 1987 to Ramsay et al; U.S. Patent No. 4,506,362 "Systematic Memory Error Detec tion and Correction Apparatus and Method" issued March 19, 1985 to Morley; U.S. Patent No. 4,493,081 "Dynamic Memory With Error Correction On Refresh" issued January 8, 1985 to Schmidt; and U.S. Patent No. 4,380,812 "Refresh and Error Detection and Correction Technique For A Data Processing System" 'issued April 19, 1983 to Ziegler, II et al.

However, all of the above references are problematic in that they effectively require that the reading of data and check bits be done outside of the DRAM, checking of the data for errors and thereafter re-writing the corrected data back into the DRAM (if necessary) in a subsequent cycle. Therefore, they effectively require at least two cycles to scrub the data and must use external error correction circuitry. This requirement for two cycles is extremely problematic when high density or mass storage of data is being utilized since time is precious.

Some additional attempts have been made to have the potential for data scrubbing and refreshing where on-board error correction circuitry is present. One such disclosure is found in the U.S. Patent No. 4,758,992 "Method and Device for Refreshing Dynamic Semiconductor Memory Device" issued July 19, 1988 to Teguchi. There, the DRAM has built-in error correction circuitry, but requires special timing during the refresh operation cycle in order to perform refresh and scrubbing operations or to perform refresh operations only. Additional special circuitry must be added to this somewhat standard DRAM in order to perform this function. Moreover, although it is possible to perform refresh and scrubbing, there is an increase in overhead in the time necessary to perform both operations as opposed to the refreshing of data exclusively.

Another method which attempts to provide on board error correction is found in U.S. Patent No. 4,748,627 "Semicon ductor Memory Device With An Error Correction Function" issued May 31, 1982 to Ohsawa. There, the error correction circuitry must be invoked by special on-chip circuitry during a row address only refresh. This circuitry has been added for the purpose of scrubbing soft errors and cannot correct hard errors in a normal data read cycle.

## Summary of the Invention

Accordingly, is is an object of the present invention to produce a device having built-in error correction circuitry which corrects hard and soft errors.

It is another object of the present invention to correct soft errors prior to a normal data read cycle.

Still a further object of the present invention is to produce a device for the overlapping of data scrubbing and refreshing without any additional on-chip circuitry or additional pins on the memory device.

Another object of the present invention is to produce a device which does not require any additional cycles in the event that soft or hard errors are detected in order to accomplish correction thereof.

Still a further object of the present invention is to produce a device which performs data scrubbing during each read and write operation for the addressed memory location.

A system for overlapped system scrubbing and data refreshing, comprising:
a semiconductor memory device for storage of data therein, said data arranged in said semiconductor memory device in a plurality of groups;
an address counter for sequentially addressing one of said plurality of said groups at a time;
refresh means dispose in said semiconductor memory device in coaction with said address counter for refreshing said one of said plurality of said groups addressed by said address counter; and
error detection and correction means disposed on said semiconductor memory device and coacting with said address counter for contemporaneous detection and correction of a portion of said one of said plurality of groups of data being refreshed.

Such a device is taught by the present invention.

## Brief Description of the Drawings

Reference may be now had to the drawings in which:
Figs. 1A and 1B are block and timing diagrams respectively of a conventional refresh scheme for a DRAM;
Figs. 2A and 2B are respectively functional and timing diagrams of data refresh and scrubbing of the DRAM in the present invention;
Fig. 3 is a block diagram of the DRAM of the present invention.

## Detailed Descrintion of the Preferred Embodiment

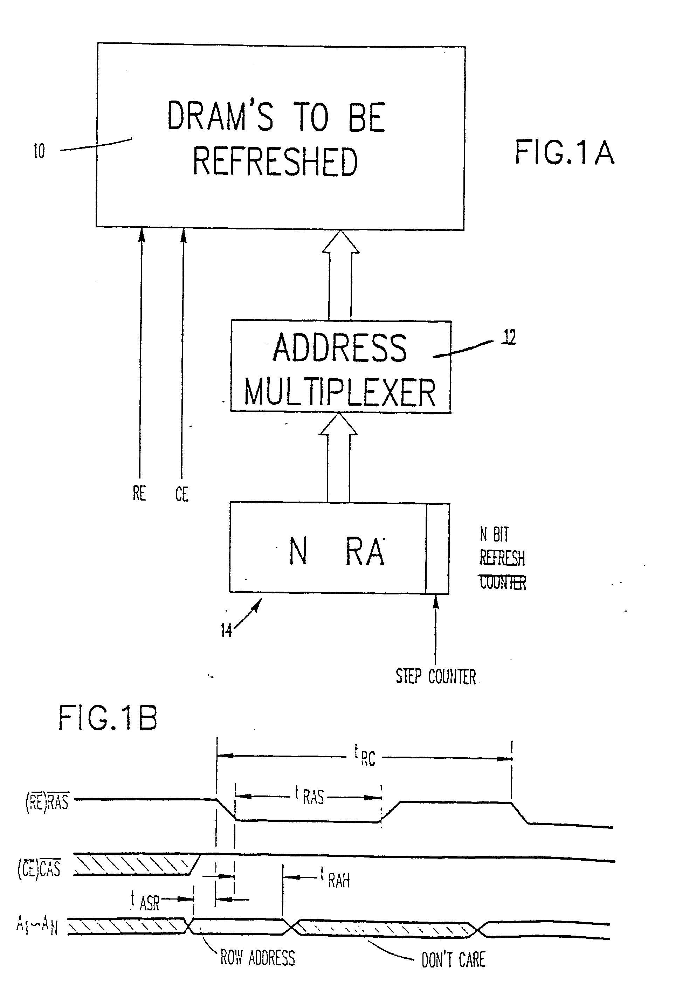

Reference may be now had to Figs. 1A and 1B illustrating conventional refresh only methodology for a previously known DRAM which provides an overview of typical DRAM and data access methodology.

Shown in block diagram form is a conventional DRAM 10 interconnected with a conventional address multiplexer 12 which is, in turn, connected with a conventional refresh counter 14. Enable lines RE and CE are used to select cells in the DRAM for access to data therein. RE and CE respectively indicate row address strobe and column address strobe for selecting and deselecting specific areas of the DRAM. Data is logically arranged in the DRAM in rows and columns which are separately addressable (i.e., a single row or a single column). During refresh, only the RE line is utilized with the result that only an individual row is enabled. Therefore, during the entire timing cycle under consideration (as seen in Fig. 1B), signal line CE remains high this is a negative active signal) with the result that none of the columns are enabled.

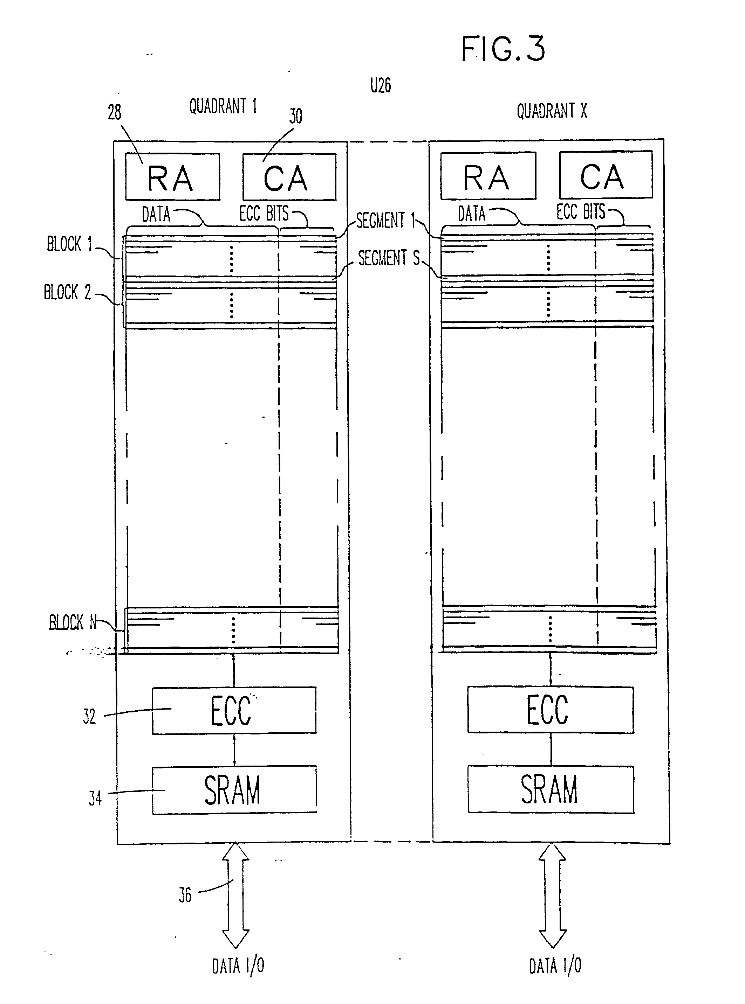

Conventional refresh counter 14 is incremented during each refresh cycle. Accordingly, the row address (RA) produced as an output of refresh counter 14 increments by one for each refresh cycle. The bit width N of the output of refresh counter 14 is determined by the size of the counts necessary to increment and hence address all areas of the entire DRAM. The output of refresh counter 14 is presented to conventional address multiplexer 12 which in turn selects the row (equivalent to a block as viewed in FIG. 3) to be accessed during a refresh cycle.

Accordingly, during refresh, an incremental row address $A_1$-$A_n$ is used. This address must remain valid for a minimum period of time ($T_{asr}$) prior to row enable RE becoming valid (low). Thereafter, row address $A_1$-$A_n$ must remain valid for a minimum period of time equal to $T_{rah}$ while similarly row enable must remain valid for $T_{ras}$ (the time of the row address strobe). After the expiration of $T_{rah}$ the row address may, and generally will, change states. The entire refresh cycle $T_{rc}$ indicates the overall time in which data refresh must occur.

During each successive $T_{rc}$ time frame, an entire row or block in the DRAM is addressed which in turn activates the cells in order to accomplish a refresh. Accordingly, refresh counter 14 is incremented which in turn passes through address multiplexer 12 for the particular segment of the DRAM 10 which is to be refreshed. The particular segment is then effectively read with the same logic state being "reintroduced" or read back into the same segment. Similarly, the error check code word associated with that particular segment will contemporaneously also be refreshed. Therefore, each "capacitor" is restored to the state it was just prior to the refresh. At the end of refresh cycle $T_{rc}$, the system in which the DRAM is operating will perform the various other functions which it was designed for and will continue doing such until the next refresh cycle $T_{rc}$ begins. Therefore, should a soft error creep into the system, it will not be detected unless and until error checking is invoked or that particular data location is read, thereby introducing or providing a path for errors. Additionally, in conventional systems, $T_{rc}$ is of a different duration than other clock timing cycles and is lengthened whenever error checking is also done. Accordingly, it has been found that it is readily possible that data having errors therein may not be used for a relatively long period of time (i.e. seconds to hours) with the result that multiple soft errors may occur.

Referring now to Fig. 3 there is shown a diagrammatic overview of the DRAM 26 of the present invention. DRAM 26 is comprised of a plurality of quadrants or sectors 1...X. Each of the quadrants or sectors is identical and for this reason only a description of quadrant 1 will be had.

Disposed in each quadrant are row address and column address buffers 28, 30 respectively. The address is multiplexed as is conventional and which is readily known to one skilled in the art. The row and column addresses are used to locate the specific points in memory in a conventional fashion.

Memory itself is comprised of a plurality af blocks consisting of block 1 through block "N". Each block is comprised of a number of segments consisting of segment 1 through segment "S". The width of each block for each segment is divided into two groups. The first group is comprised of data bits and is "D" wide. The second group is comprised of error correction code bits. The number of error correction code bits is determined by the number of data bits and the particular code which is utilized.

In the preferred embodiment of the present invention, Hamming code is utilized for error correction, although other types of codes can and may be utilized without departing from the spirit and scope of the present invention. Hamming code error correct- ion allows for single error correction and double error detection for any soft or hard error in each segment. Interconnected with the memory area of each quadrant is on-board error correction circuitry 32 which, as is readily known and available to one skilled in the art, is used to read incoming data to be stored in memory and to also generate an error correction code for storage alongside each segment of data. Similarly, error correction circuitry 32 is utilized upon any downloading of data from memory locations whether it is for reading or writing into the system or during a refresh/scrubbing cycle as described below. Error correction circuitry 32 utilizes the error correction code word to detect errors in each of the segments which is being addressed. Interconnected with error correction circuitry 32 is static random access memory (SRAM) 34 which is utilized for uploading or downloading any data into or out of memory locations. In this regard, it retrieves or places data from or onto I/O data bus 36 and in effect acts as a buffer.

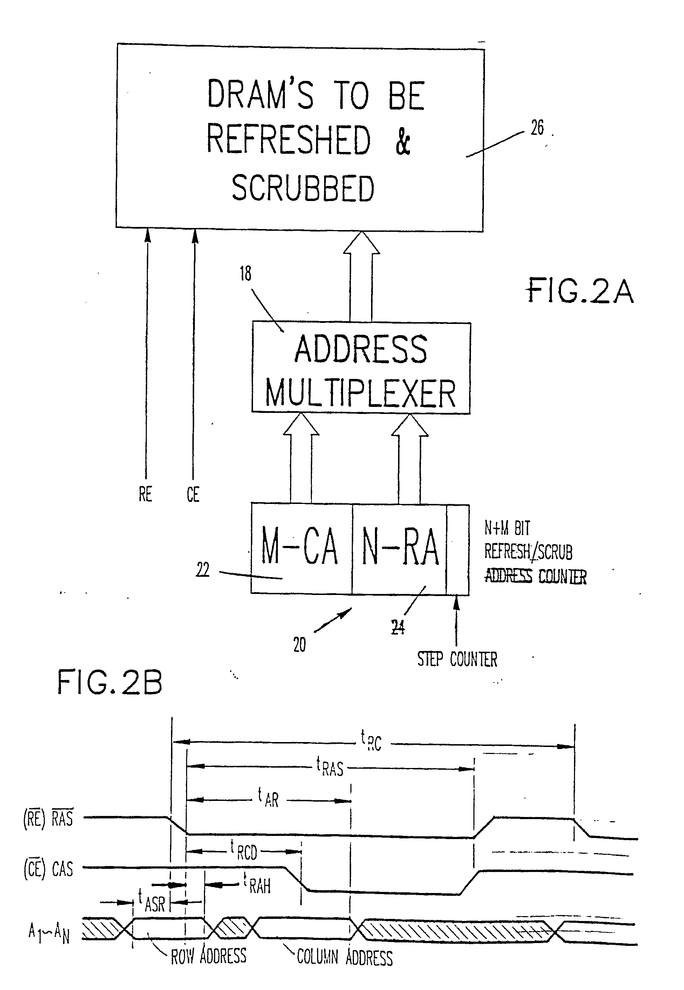

Referring to Fig. 2A, DRAM 26 has interconnected to it address multiplexer 18 which, in turn, is interconnected to a refresh/scrub counter 20. Refresh/scrub counter 20 is comprised of column address counter 22 and row address counter 24. It should be noted that at this point refresh/scrub counter 20 is substantially identical in operation to conventional refresh counter 14 and, for purposes of understanding its operation, may be viewed as a "secondary" or "local" row and column address. However, while conventional refresh counter 14 only has enough bit width to accomplish row address, refresh/scrub counter 20 has an extended bit width. These additional bits "M" are utilized to accomplish column address. This column address is used to point to a segment in the block being addressed. Accordingly, the address bus is used to first indicate which row address is to be refreshed and is then used to indicate which segment is to be scrubbed. This additional or scrubbing address is in effect loaded as the column address. Therefore, the refresh/scrub cycle which is performed during each refresh cycle is essentially identical to a read operation with the proviso that the output or chip enable line is deactivated. This segment scrub is, as mentioned, done contemporaneously with a block refresh and can be said to be a scrub "under" the refresh. Accordingly, by way of example, should each block be comprised of 8 segments (S = 8), then the number of column address bits M would be 3 ($2^3$ = 8).

During system operation and by way of example, when writing data to an individual quadrant, the contents of the address are first loaded from the I/O data bus 36 into the SRAM 34. The data to be written is updated using the appropriate column address bits as is readily known by one skilled in the art and a new error correction code word is generated and is contemporaneously written into the memory array. Similarly, upon reading from a quadrant, the segment including error code word is checked using the mentioned Hamming code for single error correction, double error detection. The data bit selected by the appropriate column address from the SRAM 34 and thereafter onto data I/O line 36.

Data refreshing and scrubbing is performed similarly. The only substantial difference is that chip enable for reading/writing data is not active and refresh/scrub counter 20, by use of column address and row address counters 22, 24 respectively, address memory locations. Accordingly, a segment in the block is addressed, read into the error correction circuitry 32, corrected and then rewritten back into its original location along with the error code.

In the preferred embodiment of the present invention, the row addresses as mentioned are supplied sequentially by the refresh circuitry. Additionally, the low order column address M is held fixed during one complete cycle through all addresses. The result is that all segments 1-S addressed by column address "M" are refreshed and scrubbed. Contemporaneously, all other segments are refreshed only. By stepping to the next column address and repeating the cycle through all row addresses, the next segment is refreshed and scrubbed. The sequence is then repeated until completed. Accordingly, all memory locations are eventually refreshed and scrubbed during successive "refresh cycles" for the memory- device. It has been found that this decreases the likelihood of two or more errors occurring per segment which is possible if it has been a long period of time since that location has been accessed for reading or writing purposes. Further, since the refresh cycle is the same length as other cycles (its width is not adjusted during operation), the addition of a scrub during each refresh cycle does not add any significant overhead in terms of time or power dissipation.

Referring now to Fig. 2B it can be seen that the timing diagram of a combined refresh and scrubbing cycle is substantially similar to conventional data refreshing with the exception that the column address strobe lead (CE) is utilized. Accordingly, the total overall refresh cycle $T_{rc}$ is identical while row address set up time $T_{asr}$ and row address hold time $T_{rah}$ are of similar duration and sequence as in Fig. 1B. The total address time is defined by $T_{ar}$. Further, with the use of column address strobe (CE), the column address lead (CE) is required to become active, i.e. low, after the row address (RE) becomes active (low) by a time equal to $T_{rcd}$, which is in effect an "overlap" time.

Accordingly, the present invention forms in substantially identical modes when performing a refresh or a scrubbing operation which is completely transparent to external devices. Additionally, all that is required to accomplish same is for additional bits and to be added to the refresh/scrub address counter 20.

It is to be understood that many variations of the present invention may be practiced without departing from the spirit and scope of the present invention. Example, different types of DRAMS may be utilized without departing from the spirit and scope of the present invention, while the timing sequence may change. Further, the quadriture or architecture of the DRAM may be different.

## Claims

1. A system for overlapped system scrubbing and data refreshing of hard and/or soft errors, comprising:
a semiconductor memory device for storage of data therein, said data arranged in said semiconductor memory device in the plurality of groups;
an address counter for sequentially address- ing one of said plurality of said groups at a time;
refresh means dispose in said semiconductor memory device in coaction with said address counter for refreshing said one of said plurality of said groups addressed by said address counter; and
error detection and correction means disposed on said semiconductor memory device and coacting with said address counter for contemporaneous detection and correction of a portion of said one of said plurality of groups of data being refreshed during a data refresh cycle.

2. A system according to claim 1 wherein said plurality of groups are comprised of blocks of data wherein each block is comprised of a plurality of segments.

3. A system according to claim 2 wherein said refresh means refreshes a block of data at a time and said portion corrected by said error detection and correction means is comprised of one of said segments in said block.

4. A system according to claim 1 wherein said semiconductor memory device is comprised of a DRAM.

5. A system according to claim 3 wherein said error detection and correction means is comprised of error correction circuitry for producing an error check code word for each, said error check code word disposed in said semiconductor memory device so as to be logically adjacent each said segment.

6. A system for overlapped data scrubbing and data refreshing of hard and/or soft errors, comprising:
a semiconductor memory device for storage of data therein, 'said data arranged in said semiconductor memory device in a plurality of blocks wherein each block is comprised of a plurality of segments and wherein each segment has logically associated with it an error check code word;
error detection and correction circuit disposed on said semiconductor memory device for detection and correction of errors in data in any one of said segments;

refresh means disposed on said semiconductor memory device for refreshing said one of said plurality of said groups at a time; and
an address counter for sequentially address- ing one of said plurality of said blocks at a time and for addressing one of said segments of said one of said plurality of said blocks, wherein said refresh means contemporaneously refreshes one of said plurality of said blocks addressed by said address counter, with said error detection means contemporaneously detecting and correcting errors in one of said segment addressed by said addressing means.

DRAM'S TO BE
REFRESHED

10

FIG.1A

ADDRESS
MULTIPLEXER

12

RE    CE

N   RA

N BIT
REFRESH
COUNTER

14

STEP COUNTER

FIG.1B

$t_{RC}$

$(\overline{RE})\overline{RAS}$

$t_{RAS}$

$(\overline{CE})\overline{CAS}$

$t_{RAH}$

$t_{ASR}$

$A_1 \sim A_N$

ROW ADDRESS

DON'T CARE

DRAM'S TO BE
REFRESHED &
SCRUBBED

26

18

FIG.2A

ADDRESS
MULTIPLEXER

RE    CE

M-CA | N-RA

N+M BIT
REFRESH/SCRUB
~~ADDRESS COUNTER~~

22

20    24

STEP COUNTER

FIG.2B

$t_{RC}$

$t_{RAS}$

$t_{AR}$

$(\overline{RE})$ $\overline{RAS}$

$t_{RCD}$

$(\overline{CE})$ CAS

$t_{RAH}$

$t_{ASR}$

$A_1 \sim A_N$

ROW ADDRESS    COLUMN ADDRESS

# FIG.3